# EUROPEAN PATENT APPLICATION

(11) **EP 2 182 277 A2**
(43) Date of publication of application: **05.05.2010**
(21) Application number: 09173999.5
(22) Date of filing: 26.10.2009
(51) Int. Cl.: F21V 29/00, F21Y 101/02

(54) **Insulating and dissipating heat structure of an electronic part**

(30) Priority: 03.11.2008 TW 97142339
(71) Applicant: Chou, Wen-Chiang, Xiangshan Dist., Hsinchu City 300 (TW)
(72) Inventor: Chou, Wen-Chiang, Xiangshan Dist., Hsinchu City 300 (TW)
(74) Representative: Jeannet, Olivier

(57) **Abstract**

An insulating and dissipating heat structure of an electronic part includes an electronic component (1), a heat sink (2) attached to one surface of the electronic component (1), a housing (3) having a first notch (31) for coupling with the heat sink (2), and fluid filled in the housing (3) for cooling. The housing (3) is made of an insulating material. The heat sink (2), the fluid, and the housing (3) of the present invention are able to lower the temperate and dissipate heat. Particularly, the housing (3) has the character of insulation to meet the safety requirements of high power electronic parts, without concerning about electric conduction and leakage.

## Description

### BACKGROUND OF THE INVENTION

### 1. Field of the Invention

The present invention relates to an insulating and dissipating heat structure of an electronic part to solve the problem of high temperature for high power electronic parts, and more particularly to one which meets the safety requirements, without concerning about electric conduction and leakage.

### 2. Description of the Prior Art

In general, an electronic part will generate thermal energy when it is working. If the temperate of the electronic part is too high, it will influence the electricity and efficiency. Sometimes, the electronic part may be damaged or there is a fire accident. Accordingly, it is very important to dissipate heat for electronic parts.

For the most popular LED chips, they transfer electric energy into light energy, accompanying with thermal energy. When the thermal energy becomes high, the light energy will be relatively decreased. The demand of dissipating heat for high power LED chips is more important. In order to ensure the safety when in use, the safety requirements are strict, without electric conduction and leakage.

### SUMMARY OF THE INVENTION

The primary object of the present invention is to provide an insulating and dissipating heat structure of an electronic part for lowering the temperature and dissipating heat.

According to the present invention, there is provided an insulating and dissipating heat structure of an electronic part, comprising:
an electronic component;
a heat sink, attached to the electronic component and made of a thermal conductive material;
a housing, made of a material which is insulating and capable of heat conduction, the housing being hollow inside and having a first notch for coupling with the heat sink; and
fluid filled in the housing, the fluid being capable of heat dissipation, cooling, and heat conduction.

The heat sink has a good heat conductivity to transfer the thermal energy from the electronic component. The heat sink has an inner surface provided with a plurality of cooling post or cooling fins.

The housing is made of an insulating material, providing an insulation effect. The housing is filled with the fluid for cooling. The cooling posts (fins) of the heat sink extend into the housing to enhance the conduction of the thermal energy from the electronic component. The cooling posts (fins) of the heat sink are used to increase the surface area for dissipating heat efficiently.

When the fluid is insulating fluid, the housing is further provided with a heat dissipating device. The heat dissipating device is to assist in transferring the thermal energy outwardly. Specifically, the fluid and the housing are in an insulating status to ensure the safety, without electric conduction and leakage.

The advantage of the present invention is that the heat sink is attached to one surface of the electronic component and coupled to the first notch of the housing; the housing is hollow inside and filled with the fluid for cooling; the housing is made of an insulating material; the heat sink, the fluid, and the housing are able to lower the temperate and dissipate heat. Particularly, the housing has the character of insulation to meet the safety requirements of high power electronic parts, without concerning about electric conduction and leakage.

### BRIEF DESCRIPTION OF THE DRAWINGS

Fig. 1 is a partially sectional view of a first preferred embodiment of the present invention;
Fig. 2 is a cross-sectional view of the first preferred embodiment of the present invention;
Fig. 3 is a partially sectional view of a second preferred embodiment of the present invention;
Fig. 4 is a cross-sectional view of the second preferred embodiment of the present invention;
Fig. 5 is a partially sectional view of a third preferred embodiment of the present invention;
Fig. 6 is a cross-sectional view of the third preferred embodiment of the present invention;
Fig. 7 is a perspective view of a fourth preferred embodiment of the present invention;
Fig. 8 is a partially sectional view of the fourth preferred embodiment of the present invention;
Fig. 9 is a partially sectional view of a fifth preferred embodiment of the present invention; and
Fig. 10 is a cross-sectional view of a sixth preferred embodiment of the present invention.

### DETAILED DESCRIPTION OF THE PREFERRED EMBODIMENTS

Embodiments of the present invention will now be described, by way of example only, with reference to the accompanying drawings.

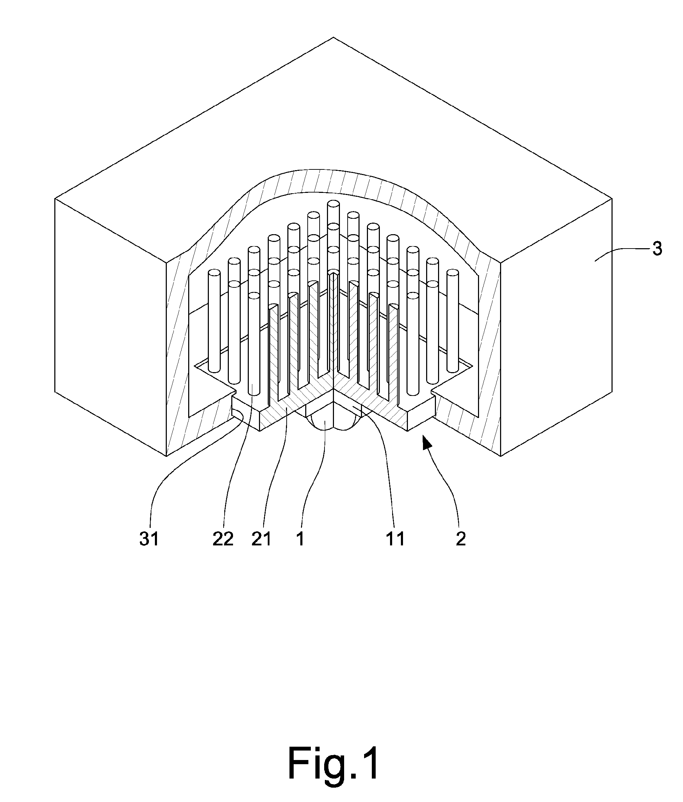

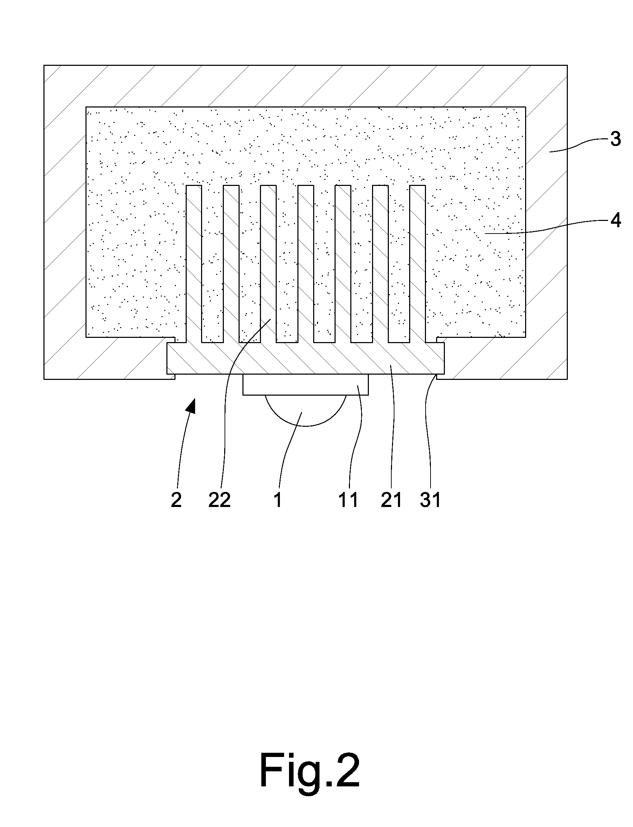

As shown in Figs. 1 and 2, a first preferred embodiment of the present invention comprises an electronic component 1, a heat sink 2, a housing 3 and fluid 4.

The electronic component 1 is a light emitting diode, a power transistor, or other electronic component which will generate thermal energy. The electronic component 1 is provided with a heat conductor 11 or integrally formed with a circuit basal plate.

The heat sink 2 is attached to one surface of the electronic component 1. The heat sink 2 is made of metal, carbon fiber, composite material or the like which conducts heat efficiently so as to efficiently conduct and dissipate thermal energy from the electronic component 1. The heat sink 2 comprises a heat conducting member 21 and a plurality of cooling posts 22 (or cooling fins). The heat conducting member 21 is attached to the heat conductor 11 or the circuit basal plate for transferring thermal energy. The cooling posts 22 are disposed on an inner surface of the heat conducting member 21 for increasing the surface area to dissipate heat and transferring the heat energy to the surrounding.

The housing 3 is made of glass, plastics, synthetic resin, ceramic, composite material or the like which is insulating and capable of heat conduction. The housing 3 is hollow inside and has a first notch for coupling with the heat conducting member 21 of the heat sink 2.

The fluid 4 is filled in the housing 3, which is preferably capable of heat dissipation, cooling, and heat conduction. The fluid 4 can be water, cooling fluid, lower concentration oil, solvent, surfactant or the like. The fluid 4 is used to transfer the thermal energy from the electronic component 1 and the heat sink 2 to the housing 3 so as to dissipate heat and lower the temperature.

When the electronic component 1 is working to generate thermal energy, the thermal energy will be quickly transferred to the fluid 4 through the heat sink 2. The fluid 4 is adapted to dissipate partial thermal energy, and then the housing 3 transfers the thermal energy outwardly to lower the temperature. In addition, the housing 3 is made of an insulating material. Thus, there is no need to concern the problem of current leakage.

The heat sink 2 is coupled to the first notch 31 in the way of heat fusion, screw connection, or adhesive for engagement and seal.

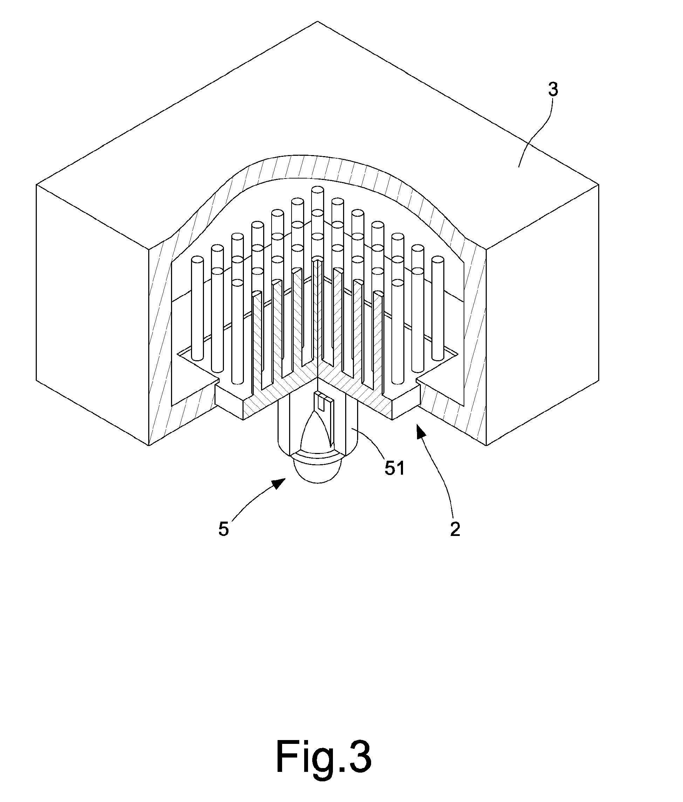

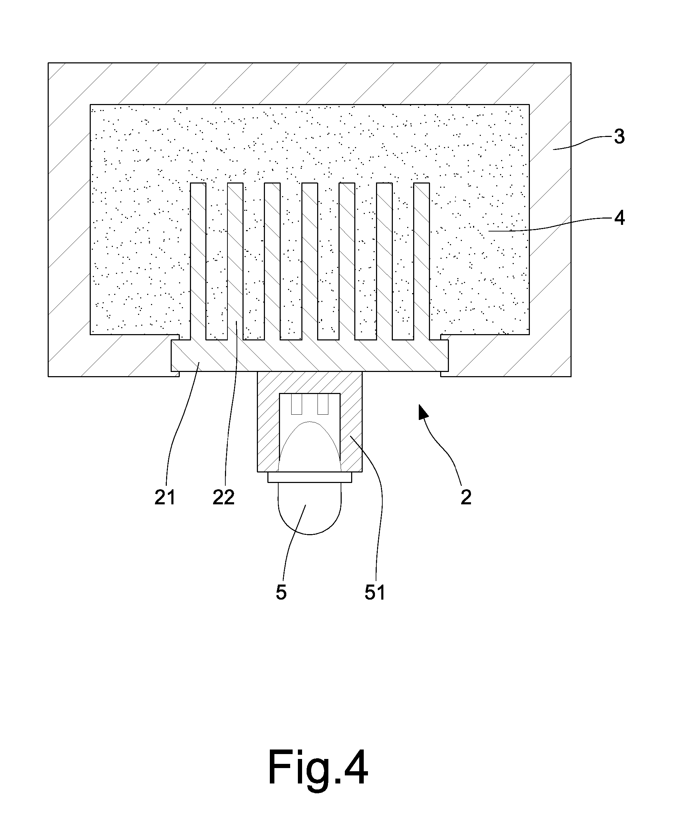

Fig. 3 and Fig. 4 show a second preferred embodiment of the present invention, which is substantially similar to the first preferred embodiment except the form of an electronic component 5. The electronic component 5 is substantially in an upright shape and also has a heat conductor 51 which is attached to the heat conducting member 21 for conducting thermal energy.

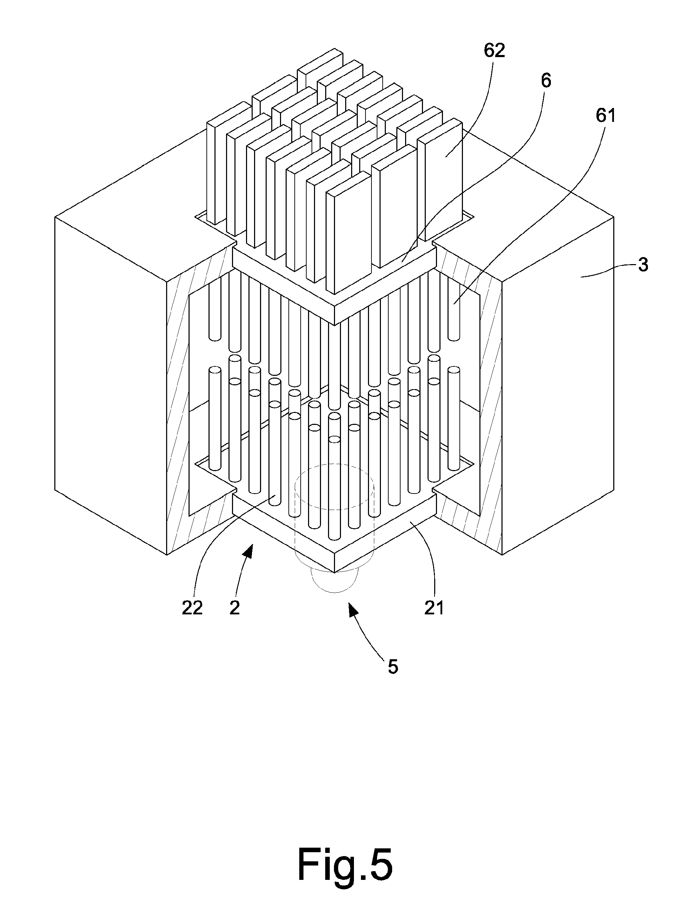

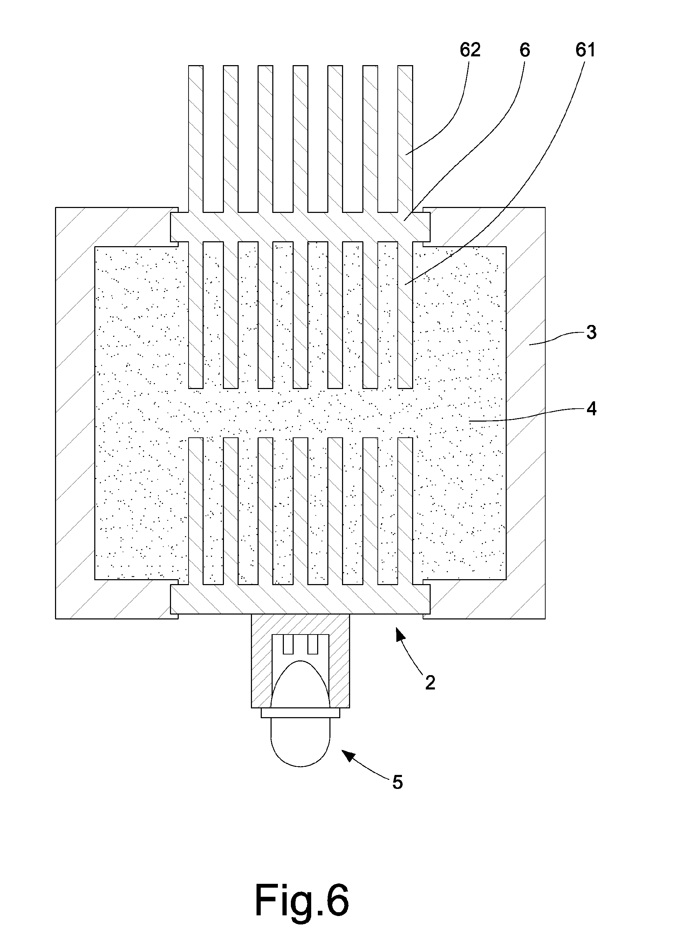

Fig. 5 and Fig. 6 show a third preferred embodiment of the present invention, which is substantially similar to the first and second preferred embodiments with the exceptions described hereinafter. The housing 3 is formed with a second notch 32 for receiving a heat dissipating device 6. The heat dissipating device 6 is made of metal, carbon fiber, composite material or the like which conducts heat efficiently so as to efficiently conduct and dissipate the thermal energy of the fluid 4 outwardly. The heat dissipating device 6 is provided with cooling posts or cooling fins 61, 62 inside and outside. In this embodiment, the fluid 4 must be insulating fluid to ensure insulation.

When the electronic component 1 is working to generate thermal energy, the thermal energy will be quickly transferred to the fluid 4 through the heat sink 2. With the heat conductivity of the fluid 4, the housing 3 and the heat dissipating device 6 are used to transfer the thermal energy outwardly to lower the temperature.

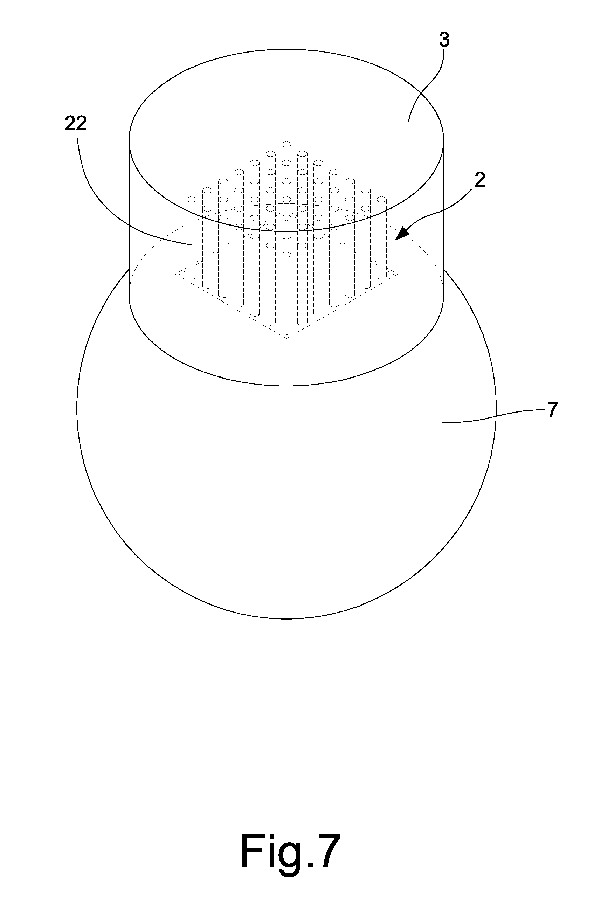

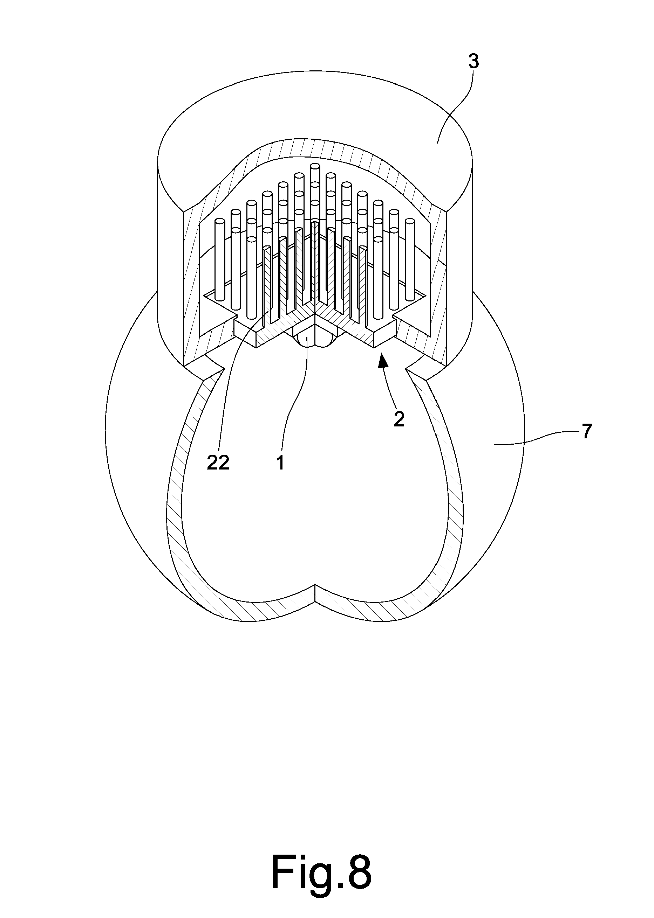

Fig. 7 and Fig. 8 show a fourth preferred embodiment of the present invention. The housing 3 is in a circular shape. The electronic component 1 is a light emitting diode chip, and may be provided with a lampshade 7 at a front end thereof, if necessary. The lampshade 7 is made of transparent glass, translucent glass, misty glass or a material which is pervious to light. Thus, the light is comfortable and not harsh to the eye. Furthermore, the lampshade 7 can be colored as desired for matching different places.

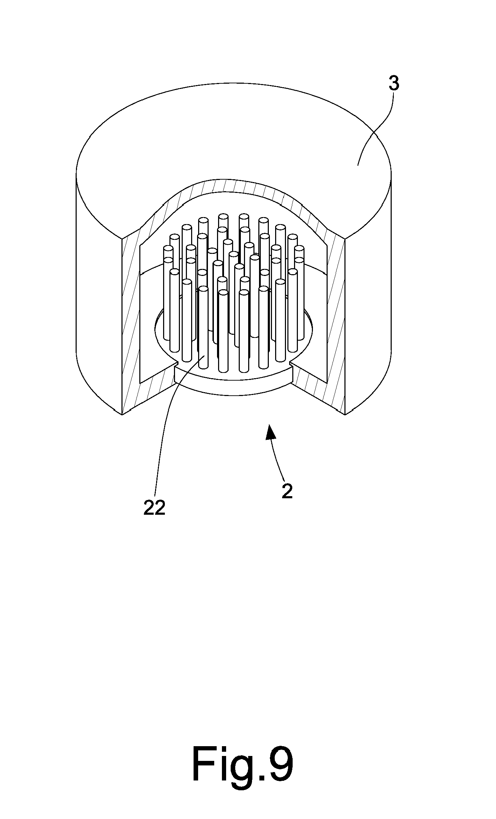

As shown in Fig. 9, the heat sink 2 and the housing 3 can be made in a round shape or other shapes.

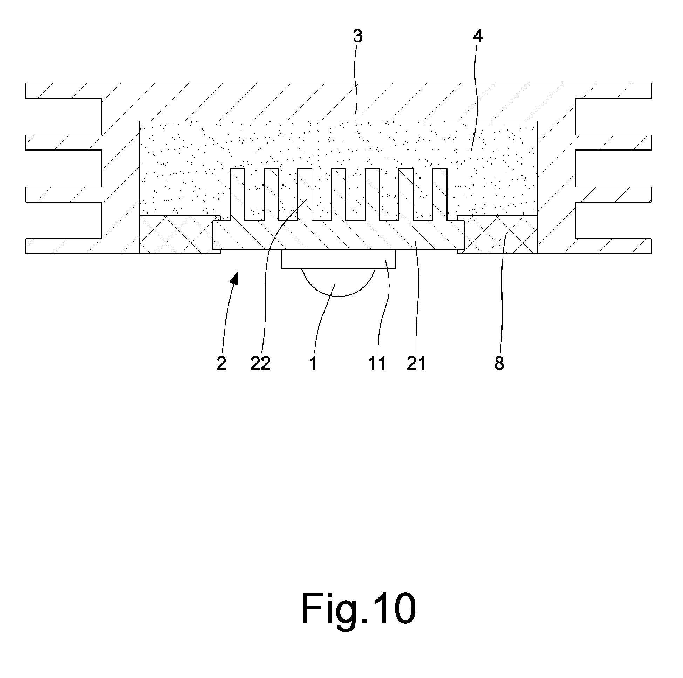

As shown in Fig. 10, there is an insulating member 8 located between the heat sink 2 and the housing 3. The insulating member 8 is made of nonconductive material, such as glass, plastics, synthetic resin, ceramic, composite material or the like. The insulating member 8 provides a nonconductive action between the heat sink 2 and the housing 3. Thus, the housing 3 may be made of not insulating material. However, the fluid 4 must be insulating.

Although particular embodiments of the present invention have been described in detail for purposes of illustration, various modifications and enhancements may be made without departing from the spirit and scope of the present invention. Accordingly, the present invention is not to be limited except as by the appended claims.

## Claims

1. An insulating and dissipating heat structure of an electronic part, **characterized in that** it comprises:
an electronic component (1, 5);
a heat sink (2), attached to the electronic component (1, 5) and made of a thermal conductive material;
a housing (3), made of a material which is insulating and capable of heat conduction, the housing (3) being hollow inside and having a first notch (31) for coupling with the heat sink (2); and
fluid (4) filled in the housing (3), the fluid (4) being capable of heat dissipation, cooling, and heat conduction.

2. The insulating and dissipating heat structure of an electronic part as claimed in claimed 1, **characterized in that** the electronic component (1, 5) is a light emitting diode or a power transistor; the electronic component (1, 5) includes a heat conductor (11, 51) or a circuit basal plate.

3. The insulating and dissipating heat structure of an electronic part as claimed in claimed 1, **characterized in that** the heat sink (2) is made of metal, carbon fiber, or a composite material thereof; the heat sink (2) includes a heat conducting member (21) attached to the electronic component (1, 5); the heat sink (2) is coupled to the first notch (31) in the way of heat fusion, screw connection, or adhesive.

4. The insulating and dissipating heat structure of an electronic part as claimed in claimed 1 , **characterized in that** the electronic component (5) includes a heat conductor (51) or a circuit basal plate; the heat sink (2) includes a heat conducting member (21) attached to the heat conductor (51) or the circuit basal plate; the heat conducting member (21) having an inner surface provided with cooling posts (22) or cooling fins.

5. The insulating and dissipating heat structure of an electronic part as claimed in claimed 1, **characterized in that** the housing (3) is made of glass, plastics, synthetic resin, ceramic, or a composite material thereof, the housing (3) is formed with a second notch (32); the second notch (32) is provided with a heat dissipating device (6), the heat dissipating device (6) is made of a thermal conductive material; the heat dissipating device (6) is provided with cooling posts or cooling fins (61, 62) inside and outside.

6. The insulating and dissipating heat structure of an electronic part as claimed in claimed 1, **characterized in that** the fluid (4) is water, cooling fluid, lower concentration oil, solvent, or surfactant.

7. The insulating and dissipating heat structure of an electronic part as claimed in claimed 1, **characterized in that** the housing (3) is in a circular shape and the housing (3) is provided with a lampshade (7) at a front end thereof.

8. The insulating and dissipating heat structure of an electronic part as claimed in claimed 7, **characterized in that** the lampshade (7) is made of transparent glass, translucent glass, misty glass or a material which is pervious to light.

9. The insulating and dissipating heat structure of an electronic part as claimed in claimed 7, **characterized in that** the lampshade (7) is colored.

10. The insulating and dissipating heat structure of an electronic part as claimed in claimed 1, **characterized in that** an insulating member (8) is provided between the heat sink (2) and the housing (3) and the insulating member (8) is made of a nonconductive material.
